# EUROPEAN PATENT SPECIFICATION

(11) **EP 3 397 955 B1**
(45) Date of publication and mention of the grant of the patent: **05.05.2021**
(21) Application number: 16826046.1
(22) Date of filing: 22.12.2016
(51) Int. Cl.: G01N 29/34, H03K 5/1532

(54) **SYSTEM AND METHOD FOR MONITORING TISSUE PROCESSING STEPS**
SYSTEM UND VERFAHREN ZUR ÜBERWACHUNG VON GEWEBEBEARBEITUNGSSCHRITTEN
SYSTÈME ET PROCÉDÉ DE SURVEILLANCE D'ÉTAPES DE TRAITEMENT DE TISSU

(30) Priority: 28.12.2015 US 201562271823 P
(43) Date of publication of application: 07.11.2018
(73) Proprietor: Ventana Medical Systems, Inc., Tucson, Arizona 85755 (US)
(72) Inventor: COOK, Brett, Tucson Arizona 85755 (US)
(74) Representative: Altmann Stößel Dick Patentanwälte PartG mbB
(86) International application number: PCT/EP2016/082375
(87) International publication number: WO 2017/114748

(56) References cited:
- WO-A1-2011/109769
- US-A- 4 121 119

## Description

### Related Application Data

The present disclosure claims the benefit of U.S. Provisional Patent Application No. 62/271,823, filed December 28, 2015.

### Field

The disclosure relates to a system and method for measuring high frequency signals that are transmitted in short bursts and detected at low voltages, and more particularly to a system and method for accurately detecting and measuring low voltage signals generated from short bursts of high-frequency ultrasound energy used to monitor tissue processing steps.

### Background

In some environments, it is desirable that it be possible to detect the amplitude of a high frequency signal with a low voltage, such as a signal having a frequency above 1 MHz and a detectable voltage of less than about 0.5 volts, where the signal is present only for a few wavelengths, for example, 20 cycles. Determining the peak amplitude of such a short sample of a waveform presents some difficulties due to the fact that the peaks are so few, of such short duration, and of such low amplitude.

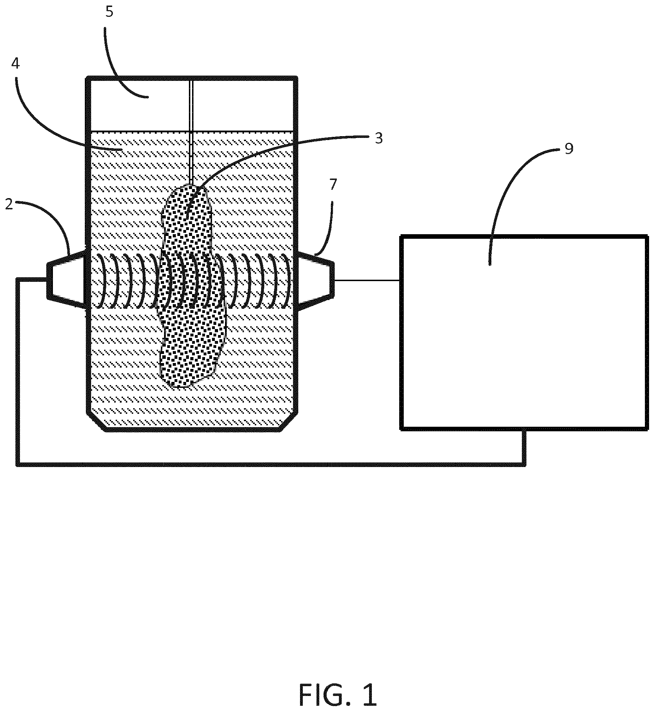

One environment where such an amplitude detector is desirable is that of a monitoring of biological sample processing operations such as fixation of tissue. An apparatus for monitoring of sample processing operations is illustrated schematically in FIG. 1. In this apparatus, a biological sample 3 is suspended in a liquid 4 in a container 5. The liquid 4 may be formalin or formaldehyde, or any other liquid, such as paraffin, an alcohol or alcoholic solution or an organic solvent such as xylene. The liquid 4 diffuses into the sample 3 until the sample is sufficiently impregnated in order to process and preserve it as close as possible to its natural state, after which time, the sample can be further processed and examined, for example, by a pathologist. In particular, where the liquid is a fixative such as formalin, excessive fixation can have a negative effect on the tissue and downstream processes, and thus monitoring the fixation process to ensure sufficient, but not excessive fixation of the tissue has occurred is desirable. Additional, more detailed examples of such systems can be found in commonly assigned, WO2011/109769.

Since the processing time for tissue depends on the tissue sample size, the type of tissue, and the density and type of fixative or other liquid, a determination of the degree of penetration of the fixative or other liquid into a tissue sample can be accomplished using an ultrasound sensor system. In the example of FIG 1, such a system includes an ultrasound emitter 2 and an ultrasound sensor, usually a piezoelectric acoustic detector 7. The emitter 2 is controlled by circuitry 9 that causes it to periodically emit ultrasound having a frequency of approximately 4 megahertz into the fluid 4 so that it passes through the fluid 4 and the sample 3 to be received by the acoustic detector 7. A sample has acoustic properties that can create a phase-shift dispersion in the ultrasound wave in the signal and/or reduce or increase its amplitude. As fluid within the sample is exchanged, the phase shift can change and/or the amplitude of the signal passing through it increases or decreases depending on the fluid and its effects on the tissue density. When the signal change(s) reaches a certain predetermined level, it can be used as an indication that the sample is adequately saturated with the exchanged fluid 4.

The signal picked up by the sensor 7 is typically a 4 megahertz signal at fairly low voltage, i.e., 0.025 to 0.25 volts, and it is preferable that it is not of long duration, e.g., on the order of 20 cycles each time the sample is probed, so as to avoid deleterious effects such as heating of the sample.

Short signals with such a low voltage and high frequency are difficult to analyze using know detection circuits. The most common known systems for detecting peak amplitudes of waveforms usually employ a diode driving a hold capacitor. However, the hold capacitor in such circuits usually charges to within about 0.7 volts of the input signal, and where the input signal is at a low voltage, such as below 0.3 volts, such as might be observed in the apparatus of FIG. 1, such circuits are unworkable to reliably detect peak amplitudes.

It is also known from US-A-4121119 a signal processing circuit for determining the amplitude of a signal of short duration, which circuit produces a D.C. voltage level corresponding to the peak amplitude of an input signal.

What is needed, therefore, is a sample monitoring system and method that can detect the amplitude of high-frequency low-voltage signals after transmission of bursts of only a few wavelengths through the sample.

### Summary

As disclosed herein, provided is a biological sample monitoring system and method that employs a circuit including a hold capacitor charged at a constant current and slew rate. The disclosed circuit also employs a comparator with small hysteresis and short delay that minimizes the possibility of over-shooting the correct amplitude voltage. This results in an output signal that incrementally climbs to the waveform voltage amplitude over a series of one to several wave cycles. The output amplitude is scalable to the low-voltage input wave amplitude range, and the rate of charge of the hold capacitor can be matched to the rate of change of the incoming signal by adjusting the magnitude of the charging current.

According to one aspect, a disclosed circuit uses a constant-current source to charge a capacitor at a selected rate to match the incoming an signal and to minimize undershoot or overshoot in the held peak value. The peak held value can be sampled and analyzed to determine a property of a biological sample through which a short burst of low voltage, high-frequency acoustic, radio or optical waves are passed.

According to another aspect, the disclosed system and method employ a circuit that is able to detect low-voltage, high-frequency signal because of a selectable charge rate and fast response of a comparator. This fast response depends on circuit components that turn the current source on and off quickly, which is accomplished via driving a base of a switch and slew-rate transistor negative. The fast response also depends on the low dispersion or variance in propagation time of the comparator, which is improved by maximizing the input overdrive.

In one embodiment a system for monitoring a biological sample is disclosed. In this embodiment, the system includes a container with a chamber, wherein the chamber contains a liquid and the biological sample is immersed in the liquid. A transmitter configured to output acoustic waves, in response to a drive signal, that pass through the biological sample located in the chamber and immersed in the liquid. A receiver positioned to detect the acoustic waves transmitted through the biological sample located in the chamber outputs a signal to a signal processing circuit. The signal processing circuit includes in this embodiment, an input gain and offset circuit component that produces a second signal in response to the output signal of the receiver that is fed into a comparator component that compares the second signal to a reference voltage to produce a third signal. The signal processing circuit further includes a current source. A switch and slew rate component receives the third signal and controls the current source according to the third signal received from the comparator component to charge a hold capacitor (either in one step or many) until a maximum voltage representative of the peak amplitude of the acoustic wave arriving at the receiver is held by the hold capacitor, this maximum voltage serving as an output signal of the signal processing circuit. A microprocessor that is part of the system of this embodiment is configured to provide the drive signal that triggers a burst of acoustic waves and is further configured to evaluate the output signal of the signal processing circuit to determine a property of the acoustic waves detected at the receiver, the property being indicative of a level of impregnation of the biological sample with the liquid contained in the chamber.

In another embodiment, a method is disclosed for evaluating a biological sample, the method including delivering an acoustic wave from a transmitter to the biological sample, detecting the acoustic wave with a receiver after the acoustic wave has traveled through the biological sample, and measuring a peak amplitude of the acoustic wave. In this embodiment, measuring the peak amplitude includes receiving a signal from the receiver,
passing the received signal through an input gain and offset circuit component to produce a second signal, passing the second signal to a comparator component that compares the second signal to a reference voltage to produce a third signal, passing the third signal to a switch and slew rate component, the switch and slew rate component controlling a current source in response to receiving the third signal from the comparator component, and
increasing a charge held by a hold capacitor using the current source until the charge held by the hold capacitor reaches a maximum, the maximum representative of the peak amplitude of the acoustic wave arriving at the receiver. The peak amplitude of the acoustic wave arriving at the receiver is indicative of a level of impregnation of the biological sample with a fluid in which the sample is immersed.

Other aspects and advantages of the disclosed system and method will become apparent from the detailed description that follows in view of the drawings as listed below.

### Brief Description of the Drawings

FIG. 1 is a diagram of a biological sample treatment system that may employ a signal processing circuit according to the disclosure.
FIG. 2 is a schematic diagram of a signal processing circuit according to the disclosure.
FIG. 3 is a detailed schematic for the circuit shown in FIG. 2.
FIG. 4 is a graph showing the input signal that may be processed by a disclosed circuit.
FIG. 5 is a graph showing a scaled output of a detector circuit according to the disclosure that is overlaid over the input waveform from which it was derived.
FIG. 6 is a diagram showing the comparative output signals or currents transmitted between portions of an embodiment of the disclosed circuit.
FIG. 7 is a schematic diagram of an alternate embodiment of disclosed detector circuit.
FIG. 8 is a schematic of an alternative embodiment of a biological sample treatment system that may employ a signal processing circuit according to the disclosure to monitor the biological sample during treatment with a liquid.

### Detailed Description

The disclosed signal processing circuit includes an amplitude detection circuit that detects the peak amplitude of a low-voltage high-frequency waveform signal, especially in situations where the signal is brief and constitutes a small number, e.g., less than 50, peaks. Any environment that requires processing of such a signal may employ the circuits and methods described herein. One specific exemplary usage of the disclosed signal processing circuit is in the biological sample treatment apparatus shown in FIG. 1, but the disclosed system and method should not be seen as limited thereto. The acoustic application is merely one of the possible uses of this circuit, and other applications, for example, for detecting optical and radio wave signals that are transmitted in short bursts and benefit from detection of peak amplitudes of low voltage and high frequency.

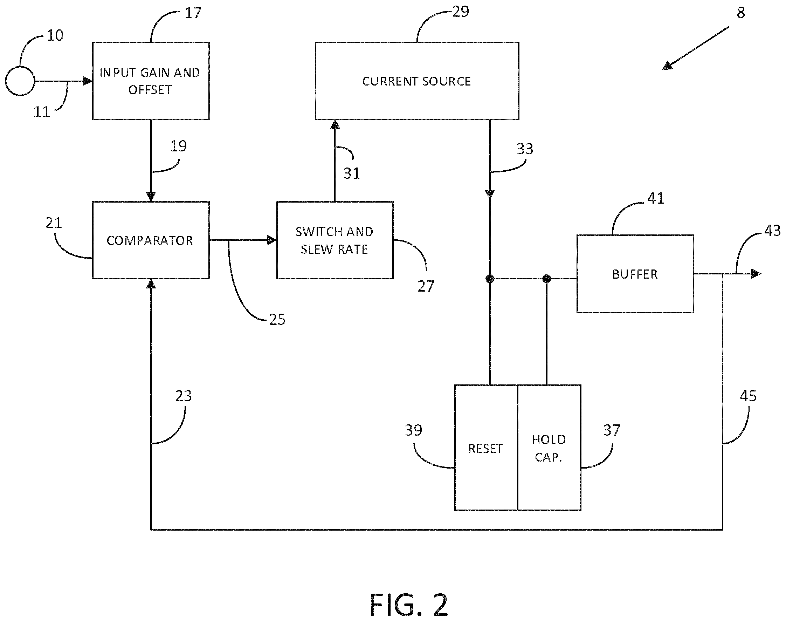

In the apparatus of FIG. 1, the level of saturation of the sample 3 with liquid 4 is tested by short bursts of ultrasound from emitter 2 that are short enough, e.g., 20 peaks, so as to have no effects other than detection of the acoustic properties of the sample 3 being saturated (for example, to avoid heating). The acoustic pickup microphone 7, such as a piezoelectric sensor, converts the ultrasound waves that have passed through the sample to a short-burst electrical signal in a wire input 10 to the signal processing circuit generally indicated at 8 in FIG. 2. The input 10 may alternatively be connected to any other source of a high-frequency low-voltage electrical signal, such as, e.g., an antenna or other signal source.

As used herein, the terms "liquid" and "fluid" are used interchangeably. Examples of liquids and fluids that can be used to treat a biological sample include fixative solutions such as formalin or other aldehyde solutions, alcohols and mixtures of alcohols and water, non-polar solvents such as xylene, and melted paraffin.

Referring to FIG. 2, input 10 supplies the signal to the remainder of the circuit 8 through a conductor 11 that carries a signal first to an input gain and an offset circuit portion 17 of the detector circuit 8. The signal of interest is a high-frequency signal, such as, e.g., 4 MHz. The incoming signal has a voltage amplitude that is generally in the range of 25 to 250 millivolts peak. The input gain and offset circuit portion 17 preferably has high- and low-pass filters that filter out frequencies in the signal that are about a decade above and below the frequency of the signal of interest, e.g., filtering out signals below 400 KHz and signals above 40 MHz for a signal of interest having a frequency of 4 MHz. The input gain and offset circuit portion 17 also amplifies the filtered signal to get the greatest amount of overdrive possible to minimize delay through a subsequent comparator 21 without exceeding the maximum input range of the comparator, say 1.5V peak for the largest input signal 10 in this example.

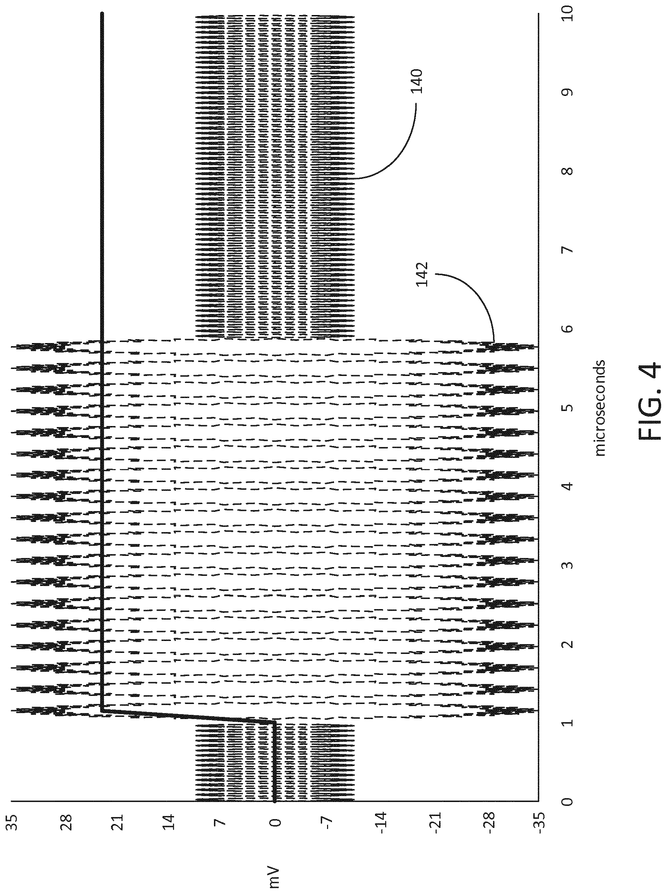

In addition, the input signal typically has noise at a level of about 10 millivolts, which is illustrated at 140 in the waveform of FIG. 4, which shows a higher-voltage amplitude data sine wave 142 combined with a lower voltage noise source 140. The input gain and offset circuit component 17 offsets the signal by approximately 10 millivolts so that the comparator 21 does not respond to the input noise.

The result is a filtered and amplified signal 19 that constitutes a high-frequency waveform signal with a frequency in the range of interest, e.g., 1 to 10 megahertz, such as about 4 megahertz with amplitude of between about 0.15 and about 1.5 volts. The filtered and amplified signal 19 proceeds from input gain and offset part 17 via a conductor to a comparator 21.

The comparator 21 compares signal 19 to signal 23. Signal 23, as will be described below, is a reference voltage corresponding in amplitude to the most recent peak signal voltage detected by the comparator 21. The initial condition of signal 23 is off, i.e., zero volts.

When a waveform signal 19 is transmitted from input gain component 17, the comparator 21 compares the detected positive amplitude of the waveform signal 19 with the amplitude of the reference voltage of signal 23. Initially, because the signal 23 is zero volts, the incoming waveform 19 triggers the comparator 21 as the waveform signal voltage passes zero volts, usually the point where the slope of the signal waveform is steepest or highest.

In the initial 180 degrees of the waveform of the signal, the voltage of the signal is greater than the zero voltage of the signal 23, and the comparator 21 switches its output to ON, i.e., outputting a current 25 having a predetermined working voltage, which is 1.7 volts DC in the illustrated embodiment, but might also be 5 volts DC or any other working voltage level. The output voltage 25 of the comparator is generally a series of square waves, the duration of each starts at half a wavelength of the signal 19 and gets progressively shorter as the voltage on the hold capacitor approaches the input voltage.

The square wave output signal is produced at 25 until such time as the voltage of the other input signal 23 on the inverting input of the comparator is greater than the amplitude of the detected peaks of the input signal 19 at the non-inverting input of the comparator. At that point, the output of the comparator switches to negative, i.e., to -1.7 volts DC and remains there as long as no higher peaks are received at the non-inverting input of the comparator.

The output signal 25 is transmitted to switch and slew rate component 27, which, when it receives a first positive signal from the comparator indicating that an input signal is received, switches on a circuit that transmits a current 31 via a conductor to current source 29. That current 31 continues to flow as long as the comparator output current 25 is positive. If output 25 flips to negative, i.e., -1.7 volts, the switch and slew rate component 27 switches off the current 31.

Current source 29 is a current mirror, as will be described further below. It is connected with a 5 volt DC power source in this embodiment. The current source 29, responsive to receiving incoming current 31, supplies an equal output current as current 33. Essentially, the current source 29 has a very high off-state impedance that prevents any current flow into the hold capacitor until the current 31 is applied to it.

Output current 33 from the current source 29 and passes through a conductor that connects to hold capacitor 37.

Hold capacitor 37 is charged by current 33. For small input signals, the capacitor can charge in a single half-cycle of the input. For larger input signals, the charge time of the hold capacitor requires more time than a single period of the input signal 19 or the resulting square wave 25. Each square wave of the signal 25 switches on the current 33 to charge the capacitor 37 further.

The hold capacitor 37 and the current source 29 are both connected to buffer 41. When the charging current 33 is switched off, the hold capacitor 37 is buffered from the comparator by component 41. In this circuit, leakage currents from the comparator inputs cannot pre-charge the hold capacitor, or drain it prematurely. Buffer component 41 in this embodiment is an inverting amplifier that is configured as a unity-gain buffer and replicates the voltage on hold capacitor 37. The buffer component 41 outputs the hold capacitor voltage along output line 43, to surrounding apparatus electronics where the signal voltage corresponds to the current detected peak voltage value for the incoming signal from input 7.

This current peak voltage is also transmitted back via line 45 to the inverting input of the comparator 21 via line 23 and compared with the input signal 19. If it is smaller in magnitude than the positive peak magnitude detected by the comparator 21, then the comparator 21 again transmits a positive square-wave signal at 25, which in turn switches on the current source 29, causing current 33 to be applied to increase the charge of the hold capacitor 37.

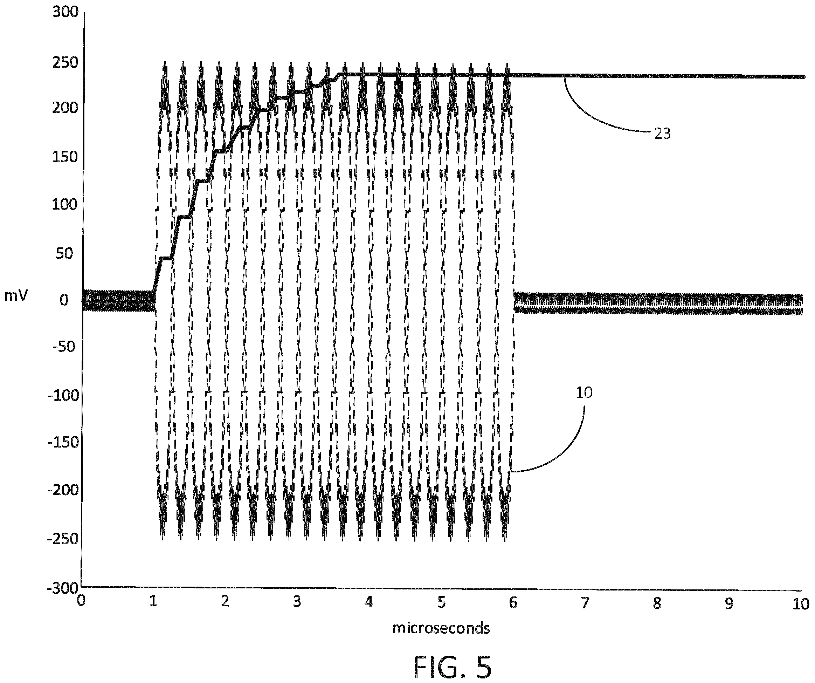

An illustration of the result of the series of square wave signals 25 and charging of the capacitor 37 is shown in FIG. 5 wherein the input signal at 10 is shown superimposed with the buffered hold-capacitor voltage sent back to the comparator 21 as signal 23. The first peak of the signal causes the capacitor to charge to a degree, after which the capacitor holds its charge in a plateau region. The next peak arrives and square wave signal 25 is output, which causes current 33 to again be applied to charge the capacitor 37 again, creating another charging increase. In the next 180 degrees of the waveform signal 15, there is no comparator output 25, so the hold capacitor maintains its voltage, which is seen as a plateau, because the hold capacitor retains its charge for many seconds, while the peaks of FIG. 4 and 5, a 4 megahertz wave, are about .25 microseconds apart. This incremental series of increases of the charge of the hold capacitor 37 continues until the voltage of signal 23 reaches a value slightly greater in magnitude than the positive peak amplitude of the input waveform signal 19. At that point, the comparator output 21 goes negative (shuts off), and the hold capacitor 37 is no longer charged. The hold capacitor maintains the resulting voltage, resulting in a high plateau as seen in FIG. 5, that extends for a long period of time and corresponds to the peak input voltage of signal 19.

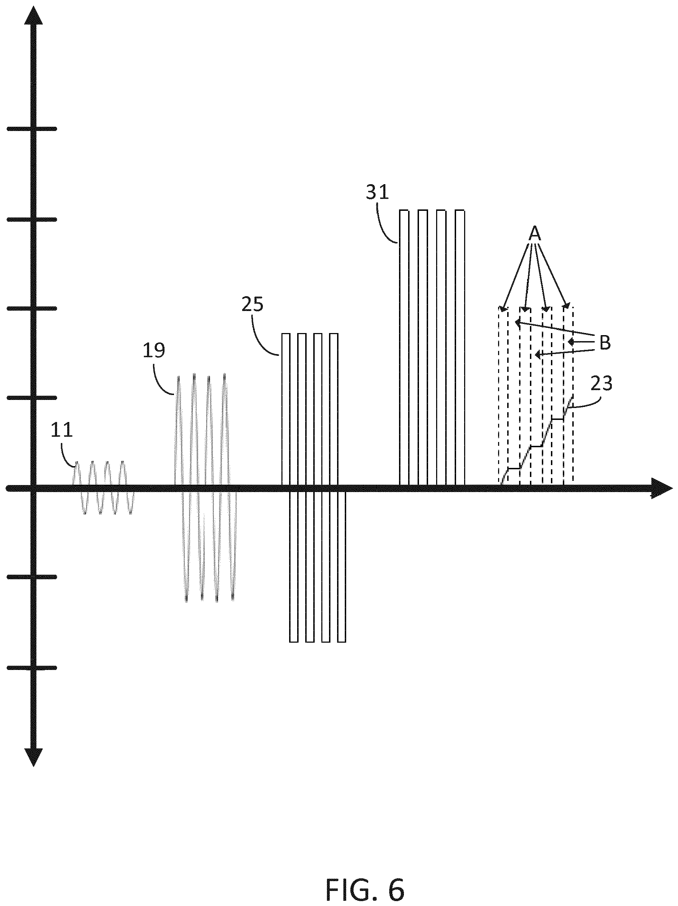

The series of outputs in the circuit is illustrated in FIG. 6, which shows four wavelengths of incoming data signal 11. The peak voltages are about 0.25 volts or less. After gain and offset component 17, signal 19 has an amplitude of about 1.25 volts. This series of waves in signal 19 produces comparator output 25 as a series of positive and negative square waves having a peak voltage of about 1.7 volts. That voltage, through the switch and slew rate 27 causes current 31 to flow from current source 29, which also produces a parallel output current 33, not shown, that charges the hold capacitor 37. The current source 29 charges the hold capacitor 37 incrementally, as shown, where the signal 23 increases in charge periods A when current 31 is allowed to flow and current 33 is on, and then plateaus in off-periods B between the spikes of current 33, when current 31 is switched off by switch component 27 and current source 29 switches off so that current 33 does not flow to the hold capacitor.

The presence of amplifier 41 between the hold capacitor 37 and the comparator 21 is especially beneficial because it prevents input bias currents of the comparator 21, from pre-charging or discharging capacitor 37, which would give an erroneous output voltage.

External circuitry, such as, e.g., controller 9 in FIG. 1, may sample the peak detected signal and act on that information. When the signal sampling is done, the external electronics can activate a reset 39. Reset 39 is essentially a switch that simply shorts both sides of the capacitor 37 together, causing the charged plate of hold capacitor 37 to fully discharge.

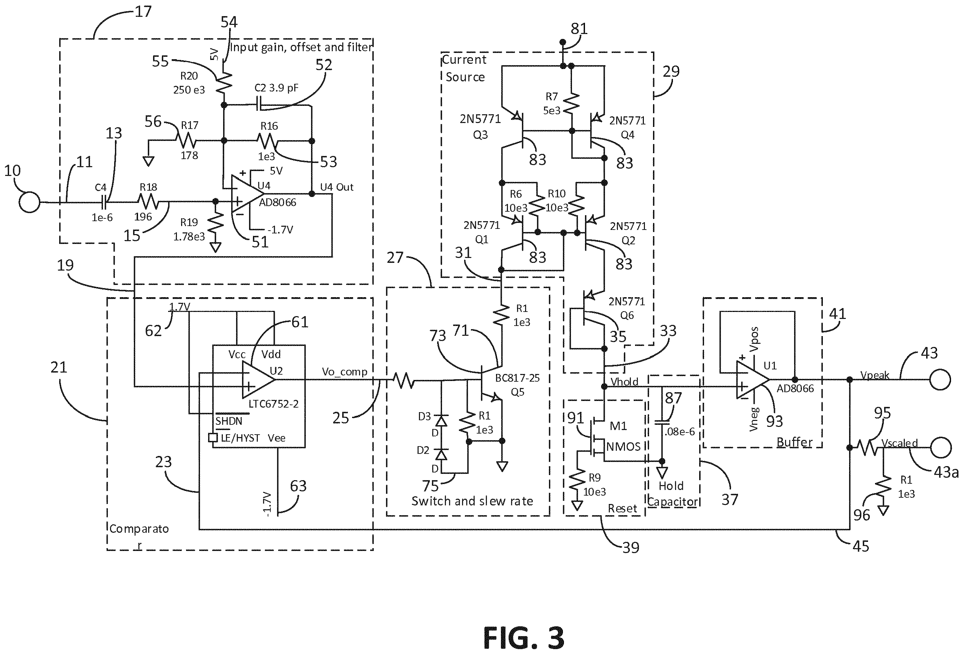

A more detailed schematic of a circuit according to FIG. 2 is seen in FIG. 3, wherein the same parts are given the same reference characters.

Input 10 connects via wire 11 to the input gain and offset portion 17. The input gain and offset portion 17 includes in wire 11 a capacitor 13 acting as a highpass filter. The capacitor has, in the preferred embodiment, a capacitance of 1 microfarad, and it filters out of input signal 10 frequencies that are 1/10 the frequency of interest or less, e.g., below 400 KHz for a signal at 4 MHz. The filtered waveform signal is transmitted along line 15.

The input gain and offset portion 17 further comprises a differential amplifier U4 identified at 51 with its non-inverting input receiving the filtered input signal from capacitor 13 along wire 15. The output of amplifier 51 is connected to the inverting input of amplifier 51 through resistor 53 and capacitor 52, which in the preferred embodiment has a capacitance of 3.9 picofarads. The capacitor 52 provides a low-pass filter that filters out frequencies of the signal that are more than a decade above the frequency of interest, which means, in the preferred embodiment, frequencies above 40 MHz from the output. The high frequency feedback is carried to the inverting input of the amplifier 51 and subtracted from the incoming signal on line 15. In addition, to reduce low-power background noise, a 5-volt power supply 54 is connected through resistor 56 to ground and through resistor 55 to the inverting input as well, so that it supplies a very low DC voltage, creating an offset of about 10 millivolts, from the amplifier 51. This is subtracted from the input signal by the amplifier resulting in an offset of the amplified signal. The gain in the signal from the amplifier is about 6, so the resulting signal is a waveform with a voltage of 0.15 to 1.5 volts.

Comparator 21 has an amplifier U2 indicated at 61 that has the signal transmitted on line 19 connected to the non-inverting input, and the signal on line 23 connected to the inverting input. The component 61 is configured such that when the difference between the input signals (sig 19 - sig 23) is positive, it outputs a =1.7 volt signal from voltage source 62. If the difference is negative, it outputs a signal of -1.7 volts from voltage source 63. The component 61 is sensitive enough to trigger the switch to positive based on a difference as small as 5 millivolts. Whichever signal, -1.7 volts or +1.7 volts, is output, it is transmitted over line 25 to switch and slew rate portion 27.

The comparator uses plus and negative markings on the inputs, but the signal applied to the negative input is also positive. If the signal on the + input is larger than the signal on the - input, the output of the comparator goes high. If the signal on the - input is larger than the signal on the + input, the comparator output goes low.

Switch and slew rate portion 27 comprises a transistor 71 that allows current to flow from its collector to its emitter when its base 73 is exposed to the positive 1.7 volt current. When the transistor 71 is passing current, it flows down to ground. When the negative 1.7 volts is applied, it cuts off current flow, and the diode and resistor loop 75 ensures that the transistor 71 is shuts off quickly and with very little leakage current until the base 73 is driven positive again. The current flows through resistor R1 from wire 31, turning on current source 29 via wire 31.

Current source 29 is configured to supply current from a power source 81. In this particular implementation, current source 29 is configured as a full Wilson current mirror that provides extremely high impedance to minimize leakage current. The current source has a set of interconnected transistors 83 that are arranged as shown so that the current at line 33 replicates or mirrors the current in line 31 when turned on by transistor 71. The Wilson current mirror is useful in this application because it provides precise current duplication or mirroring over a wide range of currents.

Transistor 35 allows transmission of the current from line 33 through it in only one direction, and it reduces the voltage across the current source. Transistor 35 also dissipates some power that would otherwise be dissipated by transistors Q2 and Q4, by reducing the voltage drop across them.

Hold capacitor 37 comprises a capacitor 87 connected to ground. Capacitor 87 is charged to the peak detected voltage. The size of capacitance is chosen, along with the charging current, to give the desired rate of change in voltage (dV/dt) to match the incoming signal rate of change. In the embodiment shown, the capacitor 87 has a capacitance of 0.08 microfarads.

Reset circuit 39 comprises a MOSFET switch indicated at 91, which shorts the two plates of capacitor 87 together to discharge capacitor 87 once the external circuit has been able to read the voltage on the hold capacitor, in preparation for reading the peak amplitude of the next burst of the input signal. The switch 91 may be operated automatically or electronically, or even manually, depending on the application of the circuit.

Amplifier 93 of buffer portion 41 has its non-inverting input connected with the capacitor 87. Its output supplies the buffered voltage to output line 43, and also is routed back to the comparator by wire 45, as has been described previously. A scaled output line 43a, in which the voltage is lowered by resistor divider 95 and 96, is connected in parallel with output 43 so as to output a scaled signal indicative of the current peak detected voltage.

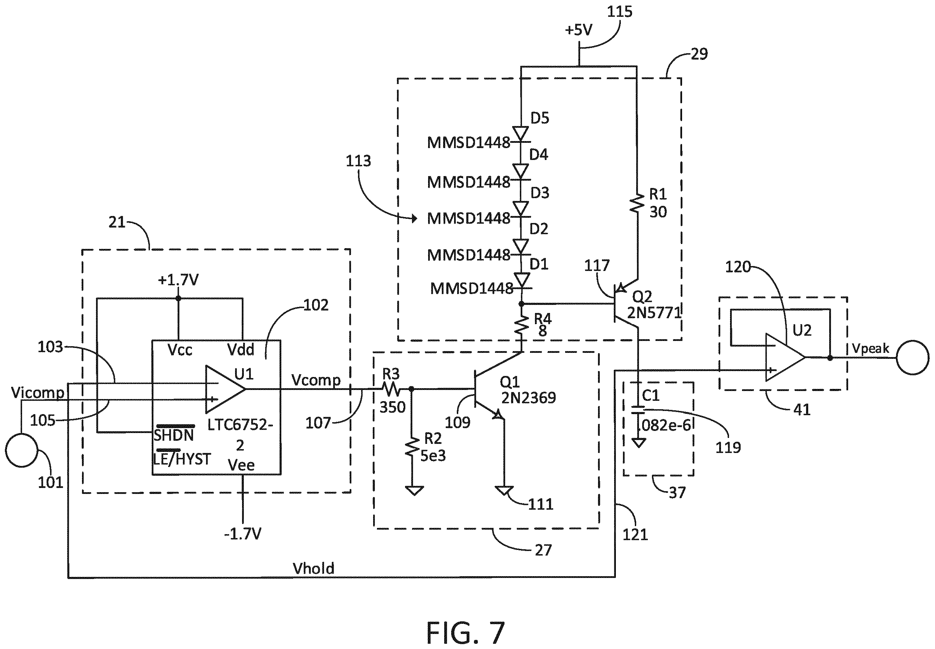

FIG. 7 shows a schematic of an alternate embodiment of detection circuit that also provides for detection of low-voltage high-frequency signals. An input 101 receives the signal to be processed. The signal of interest, as in the previous embodiment, has an amplitude of 25 to 250 millivolts and a frequency of about 4 megahertz. The waveform is applied via line 105 to the non-inverting input of a comparator 102 that is configured similarly to the comparator 21 in the previous embodiments. The inverting input of the comparator 102 is connected with line 103 which leads back from a hold capacitor. The comparator compares the signals on the two inputs 103 and 105 similarly to comparator 21 described in the previous embodiment, and, if the voltage of the signal on line 105 is greater than the magnitude of the signal on line 103, the comparator 102 outputs a signal of positive 1.7 volts. If the magnitude of the voltage of the signal on line 103 is greater than the voltage of the signal on line 105, the comparator 102 outputs a signal of negative 1.7 volts DC. For the purposes of processing a waveform signal, the output of the comparator 102 is a series of square-waves, similar to signal 25 in FIG. 6.

The output signal proceeds along line 107 through resistor R3 to the base of transistor 109. Responsive to a positive 1.7 volt output, transistor 109 turns on to permit flow of current to ground at 111. This current flows through a stack of diodes 113 connected with 5 volt power source 115. The current through these diodes 113 turns on transistor 117 to charge hold capacitor 119. Hold capacitor 119 in this embodiment has a capacitance of 0.082 microfarads.

The charged plate side of the hold capacitor 119 is connected by wire 121 to line 103 and back to comparator 102. When charged, the hold capacitor 119 also drives the input to buffer amplifier 120, which outputs the currently detected peak value of the input signal.

This system operates generally similarly to the earlier embodiments, in that the square wave pulse outputs from comparator 102 turn on the current source 29 so that it charges the hold capacitor 119 incrementally. The charge of the capacitor 119 is increased until it reaches the voltage of the input signal, at which point, the current source is switched off, and the hold capacitor remains at its charge level.

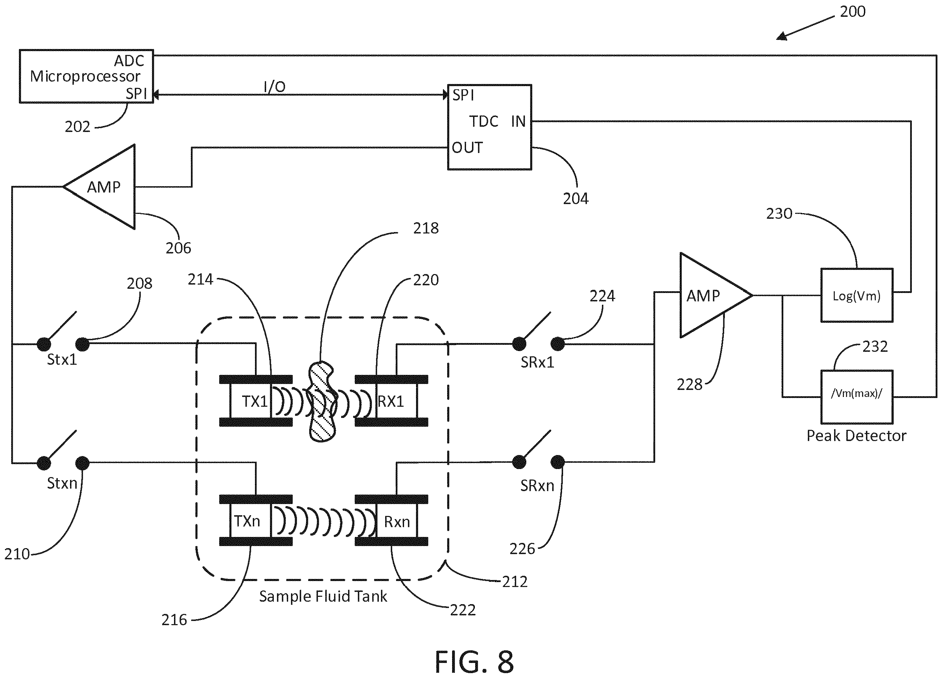

FIG. 8 shows another embodiment of a sample treatment monitoring system 200 that can utilize the previously described circuitry. In this embodiment, the system includes a microprocessor 202 that controls a Time to Digital Converter (TDC) 204. The TDC 204 sends a pulse, which may be amplified by amplifier 206 to one or more, multiplexed, ultrasound transducers 214, 216 in a fluid-filled tank 212. The one or more multiplexed transducers can be utilized individually, such as alternatively, or together, to pass sound waves either through one or more portions of a sample 218, or as shown, to provide a signal of the waves passing through the sample, 218, and a reference signal generated by sound waves do not pass through the sample. Control of which of the transducer/receiver pairs 214/220 and 216/222 are utilized for a give pulse of ultrasound is accomplished using signal and receiving switch pairs 208/224 and 210/226, respectively. The ultrasonic waves generated by transducers 214, 216, pass through the fluid and/or the sample 218, and arrive at receivers 220, 222 sometime later, possibly with a shift in phase and/or change in amplitude. Typically, some of the signal is absorbed in the process(es), reducing the amplitude of the received signal. For the ultrasound passing through the sample, the time taken or phase shift is determined by the type of sample, and the extent to which a fluid (such as a fixative) in the fluid-filled tank 212 has exchange with any fluid that was in the sample when it was first place in the fluid-filled tank 212. The signal(s) received at receivers 220, 222 can be passed through amplifier 228, an then passed through a log amp (230) and a peak detector (232) as previously described. The log amp serves to limit the dynamic range of the signal that is sent to the TDC in order to minimize the change in delay due to signal amplitude (dispersion). Dispersion varies with the overdrive level of the input comparator in the TDC 204. The signal amplitude is determined by the peak detector 232, which can be used by the microprocessor 202 to correct for any remaining dispersion in the TDC 204.

Other forms of circuits employing features of the circuits disclosed herein may be used to process a high-frequency low-voltage signal. Moreover, the terms herein should be read as terms of description rather than of limitation, as those with this disclosure before them will be able to make changes and modifications thereto without departing from scope of the disclosure.

## Claims

1. A system for monitoring a biological sample (3), comprising:
a. a container (5) with a chamber, wherein the chamber contains a fluid (4) and the biological sample (3) is immersed in the liquid (4);
b. a transmitter (2) configured to output acoustic waves, in response to a drive signal, through the biological sample (3) located in the chamber and immersed in the fluid (4);
c. a receiver (7) positioned to detect the acoustic waves transmitted through the biological sample (3) located in the chamber and immersed in the fluid (4), the receiver configured to output a signal;
d. a signal processing circuit (8) to receive the signal output from the receiver; and
e. a microprocessor (202) configured to provide the drive signal that triggers a burst of acoustic waves and further configured to evaluate the output signal of the signal processing circuit (8) to determine a property of the acoustic waves detected at the receiver, the property being indicative of a level of impregnation of the biological sample (3) with the fluid (4) in the chamber of the container (5);
**characterised in that** the signal processing circuit comprises:
i. an input gain and offset circuit component (17) that produces a second signal,
ii. a comparator component (21) that compares the second signal to a reference voltage to produce a third signal,
iii. a current source (29),
iv. a switch and slew rate component (27), the switch and slew rate component controlling the current source (29) in response to receiving the third signal from the comparator component (21), and
v. a hold capacitor (37) that is charged by the current source (29) until reaching a maximum, the maximum representative of the peak amplitude of the acoustic wave arriving at the receiver (7) and serving as an output signal.

2. The system of claim 1, further comprising a buffer component (41) between the comparator (21) and the hold capacitor (37), the buffer component (41) configured to prevent input bias currents from pre-charging or discharging the hold capacitor (37).

3. The system of claims 1 or 2, wherein the current source (29) is configured to charge the hold capacitor (37) incrementally as successive peaks of the burst of acoustic wave reach the receiver.

4. The system of any of claims 1 to 3, wherein the current source (29) comprises a current mirror within the switch and slew rate component (27) configured match a second current source that provides current so long as the third signal coming from the comparator (21) is positive.

5. The system of any of claims 2 to 4, wherein the buffer component (41) comprises an inverting amplifier configured as a unity-gain buffer that replicates the voltage on the hold capacitor (37).

6. The system of any of claims 1 to 5, wherein the reference voltage comprises a current peak voltage that is transmitted back to the comparator (21) for comparison to the second signal coming from the input gain and offset circuit (17), wherein
a. if the current peak voltage is less than a voltage of a current second signal from the input gain and offset circuit, the comparator component (21) transmits an additional third signal to the switch and slew rate component (27) which provides and additional current to the hold capacitor (37) and thereby increases the charge of the hold capacitor (37); or
b. if the current peak voltage is higher than a current second signal from the input gain and offset circuit (8), the comparator component (21) shuts off and the charge of the hold capacitor (37) is not further increased.

7. The system of any of claims 1 to 6 further comprising a reset component controlled by the microcontroller to discharge the hold capacitor (37) between bursts of output acoustic waves.

8. The system of any of claims 1 to 7, comprising two or more transmitter/receiver pairs controlled by and monitored by the microprocessor through the signal processing circuit (8).

9. The system of claim 8, wherein at least one of the two or more transmitter/receiver pairs provides a reference signal that passes through the fluid (4) in the chamber of the container (5) but not through the sample (3).

10. The system of any of claims 1 to 9, wherein input gain and offset component (21) further includes a low pass filter and a high pass filter.

11. The system of any of claims 1 to 10, wherein the acoustic waves are ultrasonic waves having a wavelength between about 400 kHz and about 40 MHz, for example, about 4 MHz.

12. A method for evaluating a biological sample (3), the method comprising:
a. delivering an acoustic wave from a transmitter (2) to the biological sample (3);
b. detecting the acoustic wave with a receiver (7) after the acoustic wave has traveled through the biological sample (3);
**characterized in that** it comprises the step of:
c. measuring a peak amplitude of the acoustic wave, wherein measuring the peak amplitude includes;
i. receiving a signal from the receiver (7);
ii. passing the received signal through an input gain and offset circuit component (21) to produce a second signal,
iii. passing the second signal to a comparator component (21) that compares the second signal to a reference voltage to produce a third signal,
iv. passing the third signal to a switch and slew rate component (27), the switch and slew rate component (27) controlling a current source (29) in response to receiving the third signal from the comparator component (21), and
v. increasing a charge held by a hold capacitor (37) using the current source (29) until the charge held by the hold capacitor (37) reaches a maximum, the maximum representative of the peak amplitude of the acoustic wave arriving at the receiver (7), wherein the peak amplitude of the acoustic wave arriving at the receiver (7) is indicative of a level of impregnation of the biological sample (3) with a fluid (4) in which the sample (3) is immersed.

13. The method of claim 12, wherein the fluid (4) comprises a fixative solution.

14. The method of any of claims 12 to 13, further comprising transmitting a reference voltage comprising a current peak voltage held by the hold capacitor (37) back to the comparator (21) for comparison to the second signal coming from the input gain and offset circuit, wherein
a. if the current peak voltage held by the hold capacitor (37) is less than the voltage of a current second signal from the input gain and offset circuit (17), the comparator component (21) transmits an additional third signal to the switch and slew rate component (27) which provides additional current to the hold capacitor (37) and thereby increases the charge of the hold capacitor (37); or
b. if the current peak voltage held by the hold capacitor (37) is higher than a current second signal from the input gain and offset circuit (17), the comparator (21) component shuts off and the charge of the hold capacitor (37) is not further increased.

## Patentansprüche

1. System zur Überwachung einer biologischen Probe (3), umfassend:
a. einen Behälter (5) mit einer Kammer, wobei die Kammer eine Flüssigkeit (4) enthält und die biologische Probe (3) in der Flüssigkeit (4) eingetaucht ist;
b. einen Sender (2), der zur Ausgabe von akustischen Wellen als Reaktion auf ein Antriebssignal durch die in der Kammer angeordnete und in der Flüssigkeit (4) eingetauchte biologische Probe (3) ausgelegt ist;
c. einen Empfänger (7), der zum Nachweis der durch die in der Kammer angeordnete und in der Flüssigkeit (4) eingetauchte biologische Probe (3) übertragenen akustischen Wellen angeordnet ist, wobei der Empfänger zur Ausgabe eines Signals ausgelegt ist;
d. eine Signalverarbeitungsschaltung (8) zum Empfangen des vom Sender ausgegebenen Signals;
e. einen Mikroprozessor (202), der zur Bereitstellung des Antriebssignals, das eine Folge von akustischen Wellen auslöst, ausgelegt ist und ferner zur Evaluierung des Ausgangssignals der Signalverarbeitungsschaltung (8) zur Bestimmung einer Eigenschaft der am Empfänger nachgewiesenen akustischen Wellen ausgelegt ist, wobei die Eigenschaft auf ein Imprägnierungsausmaß der biologischen Probe (3) mit der Flüssigkeit (4) in der Kammer des Behälters (5) hinweist;
**dadurch gekennzeichnet, dass** die Signalverarbeitungsschaltung das Folgende umfasst:
i. eine Eingangsverstärkungs- und Offset-Schaltungskomponente (17), die ein zweites Signal erzeugt,
ii. eine Komparatorkomponente (21), die das zweite Signal mit einer Bezugsspannung vergleicht, um ein drittes Signal zu erzeugen,
iii. eine Stromquelle (29),
iv. eine Schalt- und Anstiegsgeschwindigkeitskomponente (27), wobei die Schalt- und Anstiegsgeschwindigkeitskomponente die Stromquelle (29) als Reaktion auf dem Empfang des dritten Signals von der Komparatorkomponente (21) steuert, und
v. einen Haltekondensator (37), der von der Stromquelle (29) bis zum Erreichen eines Maximums geladen wird, wobei das Maximum für die Spitzenamplitude der am Empfänger (7) ankommenden akustischen Welle repräsentativ ist und als ein Ausgangssignal dient.

2. System nach Anspruch 1, ferner umfassend eine Pufferkomponente (41) zwischen dem Komparator (21) und dem Haltekondensator (37), wobei die Pufferkomponente (41) dazu ausgelegt ist zu verhindern, dass Eingangsruheströme den Haltekondensator (37) vorladen oder entladen.

3. System nach Anspruch 1 oder 2, wobei die Stromquelle (29) dazu ausgelegt ist, den Haltekondensator (37) schrittweise zu laden, wenn aufeinanderfolgende Spitzen der Folge akustischer Wellen den Empfänger erreichen.

4. System nach einem der Ansprüche 1 bis 3, wobei die Stromquelle (29) einen Stromspiegel innerhalb der Schalt- und Anstiegsgeschwindigkeitskomponente (27) umfasst, der dazu ausgelegt ist, mit einer zweiten Stromquelle zusammenzupassen, die Strom bereitstellt, solange das vom Komparator (21) kommende dritte Signal positiv ist.

5. System nach einem der Ansprüche 2 bis 4, wobei die Pufferkomponente (41) einen invertierenden Verstärker umfasst, der als Einheitsverstärkungspuffer ausgelegt ist, der die Spannung am Haltekondensator (37) repliziert.

6. System nach einem der Ansprüche 1 bis 5, wobei die Bezugsspannung eine aktuelle Spitzenspannung umfasst, die für einen Vergleich mit dem von der Eingangsverstärkungs- und Offset-Schaltung (17) kommenden zweiten Signal zurück zum Komparator (21) übertragen wird, wobei
a. wenn die aktuelle Spitzenspannung geringer als eine Spannung eines aktuellen zweiten Signals von der Eingangsverstärkungs- und Offset-Schaltung ist, die Komparatorkomponente (21) ein zusätzliches drittes Signal an die Schalt- und Anstiegsgeschwindigkeitskomponente (27) überträgt, die einen zusätzlichen Strom für den Haltekondensator (37) bereitstellt und dadurch die Ladung des Haltekondensators (37) erhöht; oder
b. wenn die aktuelle Spitzenspannung höher als ein aktuelles zweites Signal von der Eingangsverstärkungs- und Offset-Schaltung (8) ist, die Komparatorkomponente (21) sich abschaltet und die Ladung des Haltekondensators (37) nicht weiter erhöht wird.

7. System nach einem der Ansprüche 1 bis 6, ferner umfassend eine Rücksetzkomponente, die vom Mikrocontroller gesteuert wird, um den Haltekondensator (37) zwischen Folgen ausgegebener akustischer Wellen zu entladen.

8. System nach einem der Ansprüche 1 bis 7, umfassend zwei oder mehr Sender/Empfänger-Paare, die vom Mikroprozessor durch die Signalverarbeitungsschaltung (8) gesteuert und überwacht werden.

9. System nach Anspruch 8, wobei mindestens eines der zwei oder mehr Sender/Empfänger-Paare ein Bezugssignal bereitstellt, das durch die Flüssigkeit (4) in der Kammer des Behälters (5), aber nicht durch die Probe (3) verläuft.

10. System nach einem der Ansprüche 1 bis 9, wobei die Eingangsverstärkungs- und Ausgleichskomponente (21) ferner einen Tiefpassfilter und einen Hochpassfilter aufweist.

11. System nach einem der Ansprüche 1 bis 10, wobei die akustischen Wellen Ultraschallwellen mit einer Wellenlänge zwischen ungefähr 400 kHz und ungefähr 40 MHz, beispielsweise ungefähr 4 MHz sind.

12. Verfahren zur Evaluierung einer biologischen Probe (3), wobei das Verfahren das Folgende umfasst:
a. Abgabe einer akustischen Welle von einem Sender (2) an die biologische Probe (3);
b. Nachweis der akustischen Welle mit einem Empfänger (7), nachdem die akustische Welle durch die biologische Probe (3) gewandert ist;
**dadurch gekennzeichnet, dass** es den Schritt umfasst:
c. Messung einer Spitzenamplitude der akustischen Welle, wobei die Messung der Spitzenamplitude umfasst:
i. Empfang eines Signals vom Empfänger (7);
ii. Weiterleiten des empfangenen Signals durch eine Eingangsverstärkungs- und Offset-Schaltungskomponente (21) zum Erzeugen eines zweiten Signals,
iii. Weiterleiten des zweiten Signals an eine Komparatorkomponente (21), die das zweite Signal mit einer Bezugsspannung vergleicht, um ein drittes Signal zu erzeugen,
iv. Weiterleiten des dritten Signals an eine Schalt- und Anstiegsgeschwindigkeitskomponente (27), wobei die Schalt- und Anstiegsgeschwindigkeitskomponente (27) eine Stromquelle (29) als Reaktion auf dem Empfang des dritten Signals von der Komparatorkomponente (21) steuert, und
v. Erhöhen einer von einem Haltekondensator (37) gehaltenen Ladung unter Verwendung der Stromquelle (29), bis die vom Haltekondensator (37) gehaltene Ladung ein Maximum erreicht, wobei das Maximum für die Spitzenamplitude der am Empfänger (7) ankommenden akustischen Welle repräsentativ ist, wobei die Spitzenamplitude der am Empfänger (7) ankommenden akustischen Welle auf ein Imprägnierungsausmaß der biologischen Probe (3) mit einer Flüssigkeit (4), in der die Probe (3) eingetaucht ist, hinweist.

13. Verfahren nach Anspruch 12, wobei die Flüssigkeit (4) eine Fixierlösung umfasst.

14. Verfahren nach einem der Ansprüche 12 bis 13, ferner umfassend die Übertragung einer Bezugsspannung, umfassend eine vom Haltekondensator (37) gehaltene aktuelle Spitzenspannung, zurück zum Komparator (21) zum Vergleich mit dem zweiten Signal, das von der Eingangsverstärkungs- und Offset-Schaltung kommt, wobei
a. wenn die vom Haltekondensator (37) gehaltene aktuelle Spitzenspannung geringer als die Spannung eines aktuellen zweiten Signals von der Eingangsverstärkungs- und Offset-Schaltung (17) ist, die Komparatorkomponente (21) ein zusätzliches drittes Signal an die Schalt- und Anstiegsgeschwindigkeitskomponente (27) überträgt, die zusätzlichen Strom für den Haltekondensator (37) bereitstellt und dadurch die Ladung des Haltekondensators (37) erhöht; oder
b. wenn die vom Haltekondensator (37) gehaltene aktuelle Spitzenspannung höher als ein aktuelles zweites Signal von der Eingangsverstärkungs- und Offset-Schaltung (17) ist, die Komparatorkomponente (21) sich abschaltet und die Ladung des Haltekondensators (37) nicht weiter erhöht wird.

## Revendications

1. Système permettant de surveiller un échantillon biologique (3), comprenant :
a. un récipient (5) doté d'une chambre, dans lequel la chambre contient un fluide (4) et l'échantillon biologique (3) est immergé dans le liquide (4) ;
b. un émetteur (2) configuré pour sortir des ondes acoustiques, en réponse à un signal d'attaque, à travers l'échantillon biologique (3) situé dans la chambre et immergé dans le fluide (4) ;
c. un récepteur (7) positionné pour détecter les ondes acoustiques émises à travers l'échantillon biologique (3) situé dans la chambre et immergé dans le fluide (4), le récepteur étant configuré pour sortir un signal ;
d. un circuit de traitement de signaux (8) pour recevoir le signal sorti du récepteur ; et
e. un microprocesseur (202) configuré pour fournir le signal d'attaque qui déclenche une salve d'ondes acoustiques et en outre configuré pour évaluer le signal de sortie du circuit de traitement de signaux (8) afin de déterminer une propriété des ondes acoustiques détectées au niveau du récepteur, la propriété faisant état d'un niveau d'imprégnation de l'échantillon biologique (3) avec le fluide (4) dans la chambre du récipient (5) ;
**caractérisé en ce que** le circuit de traitement de signaux comprend :
i. un composant de circuit de gain et décalage d'entrée (17) qui produit un deuxième signal,
ii. un composant comparateur (21) qui compare le deuxième signal à une tension de référence pour produire un troisième signal,
iii. une source de courant (29),
iv. un composant de commutation et vitesse de balayage (27), le composant de commutation et vitesse de balayage commandant la source de courant (29) en réponse à la réception du troisième signal en provenance du composant comparateur (21), et
v. un condensateur de maintien (37) qui est chargé par la source de courant (29) jusqu'à atteindre un maximum, le maximum représentant l'amplitude de crête de l'onde acoustique arrivant au niveau du récepteur (7) et servant de signal de sortie.

2. Système selon la revendication 1, comprenant en outre un composant tampon (41) entre le comparateur (21) et le condensateur de maintien (37), le composant tampon (41) étant configuré pour empêcher que des courants de polarisation d'entrée préchargent ou déchargent le condensateur de maintien (37).

3. Système selon la revendication 1 ou 2, dans lequel la source de courant (29) est configurée pour charger le condensateur de maintien (37) par incréments à mesure que des crêtes successives de la salve d'ondes acoustiques atteignent le récepteur.

4. Système selon l'une quelconque des revendications 1 à 3, dans lequel la source de courant (29) comprend un miroir de courant dans le composant de commutation et vitesse de balayage (27) configuré pour correspondre à une seconde source de courant qui fournit du courant du moment que le troisième signal provenant du comparateur (21) est positif.

5. Système selon l'une quelconque des revendications 2 à 4, dans lequel le composant tampon (41) comprend un inverseur configuré en tant que tampon de gain unitaire qui réplique la tension sur le condensateur de maintien (37).

6. Système selon l'une quelconque des revendications 1 à 5, dans lequel la tension de référence comprend une tension de crête actuelle qui est retransmise au comparateur (21) pour une comparaison au deuxième signal provenant du circuit de gain et décalage d'entrée (17), dans lequel
a. si la tension de crête actuelle est inférieure à une tension d'un second signal actuel provenant du circuit de gain et décalage d'entrée, le composant comparateur (21) transmet un troisième signal supplémentaire vers le composant de commutation et vitesse de balayage (27) qui fournit un courant supplémentaire au condensateur de maintien (37) et de ce fait augmente la charge du condensateur de maintien (37) ; ou
b. si la tension de crête actuelle est supérieure à un deuxième signal actuel provenant du circuit de gain et décalage d'entrée (8), le composant comparateur (21) s'arrête et la charge du condensateur de maintien (37) n'est plus augmentée.

7. Système selon l'une quelconque des revendications 1 à 6 comprenant en outre un composant de réinitialisation commandé par le microcontrôleur pour décharger le condensateur de maintien (37) entre des salves d'ondes acoustiques de sortie.

8. Système selon l'une quelconque des revendications 1 à 7, comprenant deux paires d'émetteurs/récepteurs ou plus commandées et surveillées par le microprocesseur par l'intermédiaire du circuit de traitement de signaux (8).

9. Système selon la revendication 8, dans lequel au moins une des deux paires d'émetteurs/récepteurs ou plus fournit un signal de référence qui passe par le fluide dans la chambre du récipient (5) mais pas à travers l'échantillon (3).

10. Système selon l'une quelconque des revendications 1 à 9, dans lequel le composant de gain et décalage d'entrée (21) comprend en outre un filtre passe-bas et un filtre passe-haut.

11. Système selon l'une quelconque des revendications 1 à 10, dans lequel les ondes acoustiques sont des ondes ultrasonores ayant une longueur d'onde entre environ 400 kHz et environ 40 MHz, par exemple, environ 4 MHz.

12. Procédé d'évaluation d'un échantillon biologique (3), le procédé comprenant :
a. l'administration d'une onde acoustique provenant d'un émetteur (2) à l'échantillon biologique (3) ;
b. la détection de l'onde acoustique avec un récepteur (7) après que l'onde acoustique s'est déplacée à travers l'échantillon biologique (3) ;
**caractérisé en ce qu'**il comprend l'étape de :
c. mesure d'une amplitude de crête de l'onde acoustique, dans lequel
la mesure de l'amplitude de crête comprend :
i. la réception d'un signal provenant du récepteur (7) ;
ii. le passage du signal reçu à travers un composant de circuit de gain et décalage d'entrée (21) pour produire un deuxième signal,
iii. le passage du deuxième signal vers un composant comparateur (21) qui compare le deuxième signal à une tension de référence pour produire un troisième signal,
iv. le passage du troisième signal vers un composant de commutation et vitesse de balayage (27), le composant de commutation et vitesse de balayage (27) commandant une source de courant (29) en réponse à la réception du troisième signal en provenance du composant comparateur (21), et
v. l'augmentation d'une charge contenue par un condensateur de maintien (37) à l'aide de la source de courant (29) jusqu'à ce que la charge contenue par le condensateur de maintien (37) atteigne un maximum, le maximum représentant l'amplitude de crête de l'onde acoustique arrivant au niveau du récepteur (7), dans lequel l'amplitude de crête de l'onde acoustique arrivant au niveau du récepteur (7) fait état d'un niveau d'imprégnation de l'échantillon biologique (3) avec un fluide (4) dans lequel est immergé l'échantillon (3).

13. Procédé selon la revendication 12, dans lequel le fluide (4) comprend une solution de fixation.

14. Procédé selon l'une quelconque des revendications 12 et 13, comprenant en outre la retransmission d'une tension de référence comprenant une tension de crête actuelle contenue par le condensateur de maintien (37) vers le comparateur (21) pour une comparaison au deuxième signal provenant du circuit de gain et décalage d'entrée, dans lequel
a. si la tension de crête actuelle contenue par le condensateur de maintien (37) est inférieure à la tension d'un deuxième signal actuel provenant du circuit de gain et décalage d'entrée (17), le composant comparateur (21) émet un troisième signal supplémentaire vers le composant de commutation et vitesse de balayage (27) qui fournit un courant supplémentaire au condensateur de maintien (37) et de ce fait augmente la charge du condensateur de maintien (37) ; ou
b. si la tension de crête actuelle contenue par le condensateur de maintien (37) est supérieure à un deuxième signal actuel provenant du circuit de gain et décalage d'entrée (17), le composant comparateur (21) s'arrête et la charge du condensateur de maintien (37) n'est plus augmentée.
